# EUROPEAN PATENT SPECIFICATION

(11) **EP 0 482 928 B1**
(45) Date of publication and mention of the grant of the patent: **22.07.1998**
(21) Application number: 91309840.6
(22) Date of filing: 24.10.1991
(51) Int. Cl.: G06F 11/00, G06F 11/20, G06F 9/26, G06F 12/06

(54) **Semiconductor memory**
Halbleiter-Speicher
Mémoire à semiconducteur

(30) Priority: 26.10.1990 JP 288905/90
(43) Date of publication of application: 29.04.1992
(73) Proprietor: NEC CORPORATION, Tokyo (JP)
(72) Inventor: Henmi, Toru, c/o NEC Corporation, Minato-ku, Tokyo (JP)
(74) Representative: Abnett, Richard Charles

(56) References cited:
- EP-A- 0 092 646
- US-A- 4 141 068
- US-A- 4 580 212

## Description

### FIELD OF THE INVENTION

This invention relates to a semiconductor memory, and more particularly to a semiconductor memory including an error correcting circuit, and to a method of operating such a memory.

### BACKGROUND OF THE INVENTION

In a semiconductor memory employing a PROM (programmable ROM or read-only memory), there are cases in which incorrect data is read from the PROM, because the PROM is poor at maintaining information correctly for reasons of its structure.

Accordingly, a known semiconductor memory used in a high reliability system includes, in addition to the main PROM for storing data, an error correcting PROM for storing correcting data calculated on the basis of the contents of the main data PROM (defined as the "main PROM" hereinafter).

In such a known semiconductor memory, the main data is corrected in accordance with the correcting data when the main data is read from the main PROM, so that correct data is supplied from the memory.

However, if the correcting data is not correct, for instance, the correcting data does not correspond to the main PROM because the content of the main PROM is changed, incorrect data is supplied from the semiconductor memory. To avoid the supply of the faulty data, the content of the error correcting PROM is required to be changed in accordance with the change of the main PROM, when, for instance, debugging of a program in the main PROM is carried out.

With the known semiconductor memory, therefore, there is a disadvantage in that the content of the error correcting PROM has to be changed at each time when the content of the main PROM is changed. This is a very troublesome procedure.

United States Patent US-A-4 580 212, filed March 22, 1982 describes a computer with a correctable PROM, in which the main PROM does not have to be amended if it is desired to change a minor portion of a program stored in it. To this end a correction ROM is provided which contains a portion of program code which is to be substituted for the corresponding portion of code in the main ROM. In this way the main ROM, which may already be installed on a motor vehicle, does not have to be altered or removed to effect program improvements. In such an arrangement, when a code is present in the correction ROM, the corresponding code in the main ROM is ignored.

Somewhat similarly, United States Patent US-A-4 141 068, filed March 24, 1977, describes a hierarchical auxiliary ROM memory system, which includes a patch ROM which can contain alterations to the program in a bulk PROM, so that changes can be made to the program in the bulk PROM by substituting corresponding new code in the patch ROM. Where such new code exists, the corresponding code in the bulk PROM is again ignored.

In neither case is the code in the secondary ROM used to check or validate the code in the main ROM.

### SUMMARY OF THE INVENTION

According to the invention, a semiconductor memory comprises a main PROM for storing main data, an error correcting PROM for storing error correcting data calculated on the basis of the contents of the main PROM, an error correcting circuit coupled to the main PROM and to the error correcting PROM for correcting the main data in accordance with the error correcting data, and control means for controlling the error correcting circuit and which is supplied with control data, the control means being operative to selectively disable the error correction of the error correcting circuit such that the main data is output without correction when the received control data indicates that the error correcting data is invalid.

The invention also provides a method of operating such a memory as defined in claim 5.

### BRIEF DESCRIPTION OF THE DRAWINGS

The invention will be explained in more detail, by way of example, in conjunction with the appended drawings, wherein:
**Figure 1** is a block diagram showing a preferred embodiment of the invention; and
**Figure 2** is a flow chart explaining operation of the preferred embodiment.

### DESCRIPTION OF THE PREFERRED EMBODIMENT

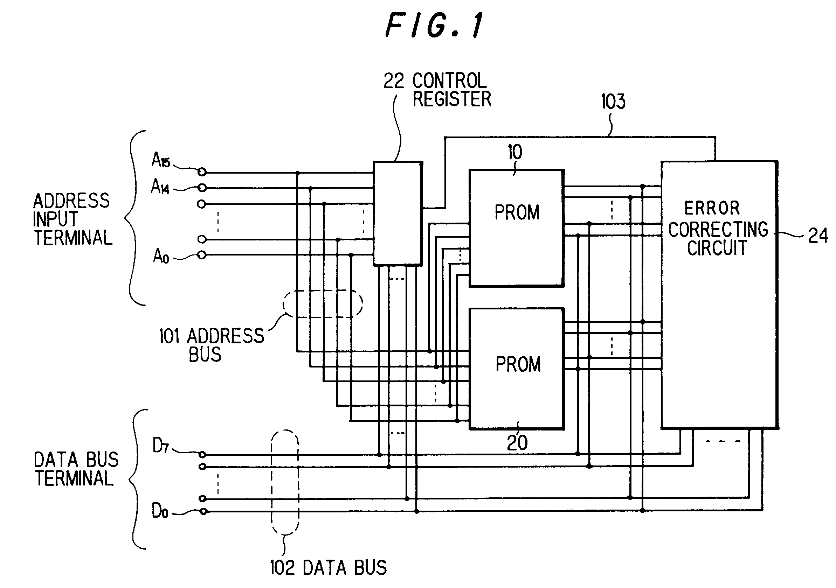

A semiconductor memory of the preferred embodiment shown in Figure 1 includes a main PROM 10 for storing main data, a correcting PROM 20 for storing correcting data, an error correcting circuit 24 connected at its inputs to the main and correcting PROMs 10 and 20 and at its output to terminals D₀ to D₇ of a data bus 102, and a control register 22 connected at its output to the error correcting circuit 24.

The main PROM 10 has a capacity of 16K bytes, and is supplied with main data from the data bus terminals D₀ to D₇ through the data bus 102. The main PROM 10 is activated when an address signal is applied thereto from address input terminals A₀ to A₁₅ through an address bus 101. Here it is assumed that the addresses of the main PROM 10 are "0000_{H}" to "3FFF_{H}" (i.e. A₁₄ = 0, A₁₅ = 0) . The error correcting PROM 20 stores correcting data calculated on the basis of the contents of the main PROM 10. The control register 22 is supplied with correction control data, and supplies a control signal 103 to the error correcting circuit 24 in which it is determined as to whether an error correcting operation should be carried out or not in accordance with the control signal 103.

Here it is assumed that the addresses of the error correcting PROM 20 and the control register 22 are "4000_{H}" to "7FFF_{H}" (i.e. A₁₄ = 1, A₁₅ = 0).

The error correcting circuit 24 is supplied with main and error correcting data from the main and error correcting PROMs 10 and 20, and corrects the main data in accordance with the error correcting data.

In a writing operation, when an address signal in the range "OOOO_{H}" to "3FFF_{H}" is applied to the address input terminals A₀ to A₁₅, the main PROM 10 is activated by the address signal, so that main data supplied to the data bus terminals D₀ to D₇ is stored in the main PROM 10. After that, when an address signal in the range "4000_{H}" to "7FFF_{H}" is applied to the address input terminals A₀ to A₁₅, the error correcting PROM 20 and the control register 22 are activated. Thus, error correcting data is stored in the error correcting PROM 20, and error correction control data is supplied to the data bus terminals D₀ to D₇ and transferred to the control register 22.

In a reading operation, when an address signal in the range "0000_{H}" to "3FFF_{H}" is applied to the main PROM 10, the main data is read therefrom to the error correcting circuit 24. After that, when an error address signal in the range "4000_{H}" to "7FFF_{H}" is applied to the error correcting PROM 20 and the control register 22, the correcting data stored in the error correcting PROM 20 is read therefrom to the error correcting circuit 24, and a control signal 103 is applied from the control register 22 to the error correcting circuit 24. Then, the main data is corrected with the correcting data by the error correcting circuit 24 and is supplied to a subsequent stage through the data bus terminals D₀ to D₇ when the error correction operation is instructed to be carried out by the control signal 103. On the other hand, when the error correction operation is instructed to be invalid by the control signal 103, the main data is supplied from the error correcting circuit 24 through the data bus terminals D₀ to D₇ to the subsequent stage without any correction.

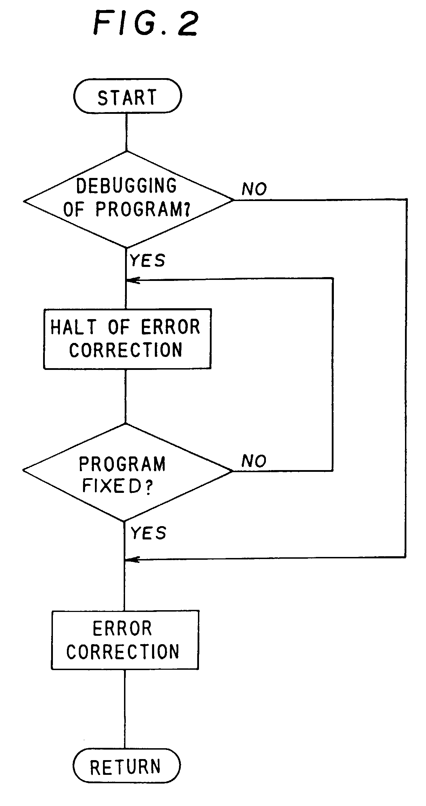

Figure 2 explains the operation of the preferred embodiment. In operation, when the debugging of a program to be stored in the main PROM 10 starts, an "INVALID" control signal 103 is applied to the error correction circuit 24, so that error correction in the error correction circuit 24 is halted, i.e. disabled. When the program is finally fixed by the debugging operation, a "VALID" control signal 103 is applied to the error correction circuit 24, so that main data read from the main PROM 10 is corrected by error correcting data supplied from the error correcting PROM 20.

In this preferred embodiment, the main PROM 10 is addressed by an address signal applied to the address terminals A₀ to A₁₃, and the error correcting PROM 20 and the control register 22 are addressed by address signals based on the content of the address terminals A₁₄, so that error in the writing of data which may occur due to the error addressing is avoided. Thus the signal on terminal A₁₄ indicates whether the main PROM, on the one hand, or the error correcting PROM and the control register, on the other, are being addressed.

As described above, the error correction circuit 24 is controlled from an external circuit, so that the troublesome procedure of writing error correcting data each time a program is modified in the debugging of the program is obviated.

It is thus seen that the illustrated embodiment provides a semiconductor memory from which correct data are read, even if the error correcting PROM is not changed in content to correspond to the change of the main PROM.

## Claims

1. A semiconductor memory comprising:
a main PROM (10) for storing main data;
an error correcting PROM (20) for storing error correcting data calculated on the basis of the contents of the main PROM;
an error correcting circuit (24) coupled to the main PROM and to the error correcting PROM for correcting the main data in accordance with the error correcting data; and
control means (22) for controlling the error correcting circuit and which is supplied with control data, the control means being operative to selectively disable the error correction of the error correcting circuit such that the main data is output without correction when the received control data indicates that the error correcting data is invalid.

2. A semiconductor memory according to claim 1, wherein the control means (22) disables the error correction during debugging of a program in the main PROM (10).

3. A semiconductor memory according to claim 1 or 2, wherein the main PROM (10), the error correcting PROM (20), and the control means (22) are all connected to a data bus (102) and an address bus (101), a first portion of the address bus being assigned to the main PROM, and a second portion of the address bus being assigned to the error correcting PROM and the control means.

4. A semiconductor memory according to claim 3, wherein the control means (22) is coupled to the address bus (101) and to the data bus (102) and supplies an output (103) to the error correcting circuit (24) to selectively disable the error correction.

5. A method of operating a semiconductor memory which comprises a main PROM (10) for storing main data and an error correcting PROM (20) for storing error correcting data, the method comprising the steps of:
writing main data into the main PROM;
calculating error correction data from the main data and writing the error correction data into the error correction PROM;
reading main data from the main PROM; and
correcting the main data read from the main PROM in accordance with corresponding error correction data in the error correction PROM; and
in which in accordance with received control data the error correction is selectively disabled and the main data is output without correction.

6. A method according to claim 5, in which the error correction is disabled during debugging of a program in the main PROM.

## Patentansprüche

1. Halbleiter-Speicher, der aufweist:
ein Haupt-PROM (10) zum Speichern von Haupt-Daten; ein fehlerkorrigierendes PROM (20) zum Speichern fehlerkorrigierender Daten, die auf der Grundlage der Inhalte des Haupt-PROMs berechnet werden;
eine fehlerkorrigierende Schaltung (24), die an das Haupt-PROM und an das fehlerkorrigierende PROM zum Korrigieren der Haupt-Daten entsprechend den fehlerkorrigierenden Daten gekoppelt ist; und
Steuereinrichtungen (22) zum Steuern der fehlerkorrigierenden Schaltung, die mit Steuerdaten versorgt wird, wobei die Steuereinrichtungen wirksam sind, die Fehlerkorrektur der fehlerkorrigierenden Schaltung selektiv zu sperren, so daß die Haupt-Daten ohne Korrektur ausgegeben werden, wenn die erhaltenen Steuerdaten anzeigen, daß die fehlerkorrigierenden Daten ungültig sind.

2. Halbleiter-Speicher nach Anspruch 1, wobei die Steuereinrichtungen (22) die Fehlerkorrektur während des Austestens eines Programms im Haupt-PROM (10) sperren.

3. Halbleiter-Speicher nach Anspruch 1 oder 2, wobei das Haupt-PROM (10), das fehlerkorrigierende PROM (20) und die Steuereinrichtungen (22) alle mit einem Datenbus (102) und einem Adreßbus (101) verbunden sind, wobei ein erster Abschnitt des Adreßbusses dem Haupt-PROM zugeordnet ist, und ein zweiter Abschnitt des Adreßbusses dem fehlerkorrigierenden PROM und den Steuereinrichtungen zugeordnet ist.

4. Halbleiter-Speicher nach Anspruch 3, wobei die Steuereinrichtungen (22) an den Adreßbus (101) und an den Datenbus (102) gekoppelt sind und einen Ausgang (103) an die fehlerkorrigierende Schaltung (24) liefern, um die Fehlerkorrektur selektiv zu sperren.

5. Verfahren zum Betreiben eines Halbleiter-Speichers, der ein Haupt-PROM (10) zum Speichern von Haupt-Daten und eine fehlerkorrigierendes PROM (20) zum Speichern von fehlerkorrigierenden Daten aufweist, wobei das Verfahren die Schritte aufweist:
Schreiben von Haupt-Daten in das Haupt-PROM;
Berechnen von Fehlerkorrektur-Daten aus den Haupt-Daten und Schreiben der Fehlerkorrektur-Daten in das Fehlerkorrektur-PROM;
Lesen von Haupt-Daten aus dem Haupt-PROM; und
Korrigieren der aus dem Haupt-PROM gelesenen Haupt-Daten entsprechend entsprechender Fehlerkorrektur-Daten im Fehlerkorrektur PROM; und
in dem entsprechend empfangenen Steuerdaten die Fehlerkorrektur selektiv gesperrt wird und die Haupt-Daten ohne Korrektur ausgegeben werden.

6. Verfahren nach Anspruch 5, in dem die Fehlerkorrektur während des Austestens eines Programms im Haupt-PROM gesperrt wird.

## Revendications

1. Mémoire à semiconducteurs comprenant :
une mémoire PROM principale (10) pour stocker des données principales ;
une mémoire PROM de correction d'erreurs (20) pour stocker des données de correction d'erreurs calculées sur la base des contenus de la mémoire PROM principale ;
un circuit de correction d'erreurs (24) couplé à la mémoire PROM principale et à la mémoire PROM de correction d'erreurs pour corriger les données principales conformément aux données de correction d'erreurs ; et,
un moyen de commande (22) pour commander le circuit de correction d'erreurs et auquel sont fournies des données de commande, le moyen de commande étant actif pour invalider sélectivement la correction d'erreurs du circuit de correction d'erreurs pour que les données principales soient sorties sans correction quand les données de commande reçues indiquent que les données de correction d'erreurs sont incorrectes.

2. Mémoire à semiconducteurs selon la revendication 1, dans laquelle le moyen de commande (22) invalide la correction d'erreurs pendant le débogage d'un programme dans la mémoire PROM principale (10).

3. Mémoire à semiconducteurs selon la revendication 1 ou 2, dans laquelle la mémoire PROM principale (10), la mémoire PROM de correction d'erreurs (20), et le moyen de commande (22) sont tous connectés à un bus de données (102) et à un bus d'adresse (101), une première partie du bus d'adresse étant affectée à la mémoire PROM principale, et une seconde partie du bus d'adresse étant affectée à la mémoire PROM de correction d'erreurs et au moyen de commande.

4. Mémoire à semiconducteurs selon la revendication 3, dans laquelle le moyen de commande (22) est couplé au bus d'adresse (101) et au bus de données (102) et fournit un signal de sortie (103) au circuit de correction d'erreurs (24) pour invalider sélectivement la correction d'erreurs.

5. Procédé pour faire fonctionner une mémoire à semiconducteurs qui comprend une mémoire PROM principale (10) pour le stockage de données principales et une mémoire PROM de correction d'erreurs (20) pour le stockage de données de correction d'erreurs, le procédé comprenant les étapes de :
écriture de données principales dans la mémoire PROM principale,
calcul de données de correction d'erreurs à partir des données principales et écriture des données de correction d'erreurs dans la mémoire PROM de correction d'erreurs ;
lecture de données principales dans la mémoire PROM principale ; et,
correction des données principales lues dans la mémoire PROM principale conformément à des données de correction d'erreurs correspondantes dans la mémoire PROM de correction d'erreurs ; et,
dans lequel, conformément à des données de commande reçues, la correction d'erreurs est invalidée sélectivement et les données principales sont sorties sans correction.

6. Procédé selon la revendication 5, dans lequel la correction d'erreurs est invalidée pendant le débogage d'un programme dans la mémoire PROM principale.
